# EUROPEAN PATENT APPLICATION

(11) **EP 4 459 340 A1**
(43) Date of publication of application: **06.11.2024**
(21) Application number: 24168431.5
(22) Date of filing: 04.04.2024
(51) Int. Cl.: G02B 6/42, G02B 6/43, H05K 1/02

(54) **A SURFACE MOUNTED OPTICAL DEVICE AND HYBRID CIRCUIT**

(30) Priority: 21.04.2023 EP 23169292
(71) Applicant: Firecomms Limited, Cork (IE)
(72) Inventor: STEPHEN, Martin, Cork (IE); DAVIS, Áine, Cork (IE); LAMBKIN, John, Cork (IE)
(74) Representative: Weldon O'Brien Ltd.

(57) **Abstract**

An electro optical apparatus has an EOCB (2) with a printed circuit board and at least one waveguide (3, 10), at least one optical aperture (20, 21, 114) in the board with a side wall aligned with a termination (116) of the waveguide. An electro optical device (30) has an optical element (31) with components (35) in encapsulation (36) on a substrate is located within the aperture (20) by the substrate (32/37) being attached to the board around a rim of the aperture by surface mount attachment with reflow of solder. The substrate may include an interposer (32) to allow design flexibility. The encapsulation (36) provides optical alignment of the component (35) with the EOCB waveguide so that the arrangement is robust, reliable and easy to manufacture. In some examples the substrate (501) and the EOCB (550) provide a Faraday cage (505, 554, 553) around the aperture and hence the optical element (530).

## Description

### Introduction

The present invention relates to an optical communication apparatus and more particularly to an optical communication module and hybrid printed circuit boards (PCBs) that include both electrical copper and optical transmission layers and such modules. Such boards are referred to as Electro-Optical Circuit Boards (EOCBs).

As the speed and complexity of the PCBs has increased, critical issues with using multiple layers of copper such as Electromagnetic Interference (EMI), cross talk interference from neighbouring copper tracks, as well board size limitations driven by the need to provide galvanic isolation from one portion of the PCB to another. One potential solution for overcoming the issues of EMI, cross talk, and galvanic isolation has been the implementation of an optical interconnection. There are many optical interconnection methods available for standard PCBs such as free space optics and board level opto-electronic components such as opto-couplers.

A further method for integrating optical interconnects into a PCB has been achieved through implementing a polymer optical layer applied on the surface or within the PCB itself. This optical layer contains at least one optical waveguide and is often referred to as the Optical Interconnect Layer. The use of an optical interconnect layer is an attractive solution as the designer has the ability to route multiple waveguides of arbitrary length around the PCB with the added flexibility to implement more complex optical elements such as splitters and combiners which cannot be easily accomplished by using conventional surface mount opto-electronic components.

An example of an optical apparatus used for coupling into an EOCB is that described in US 7,239,767 (Kim et al), which describes an optical emitting source mounted on a substrate with electrical contacts or metal bond pads used in combination with an optical interconnection block inserted into the via hole or aperture of the EOCB. The combined sub-assembly of substrate and optical device, in this instance, is flipped and using a solder reflow process become attached to metal bond pads and solder bumps located on the top surface of the EOCB such that the optical source is positioned over the optical element contained within or inserted into the via hole or aperture of the EOCB which enables the emitted optical beam to be coupled into the waveguide. A difficulty therefore arises in achieving maximum optical throughput to and from the EOCB due to the need to assemble and align a significant number of independent components with separate degrees of freedom. This difficulty is therefore likely to reduce the yield and increase cost of implementing out-of-the-plane coupling. A disadvantage of the prior art configuration for coupling light to and from the EOCB is that it does not provide good protection against electromagnetic interference particularly in the case of light coupling from the EOCB waveguide to a photodetector where the photodetector by virtue of the small photocurrents generated is particularly susceptible to interference. Also, US2010/0215314 (Lau et al) describes an optoelectronic apparatus with an embedded 3D hybrid integrator. Again, there is need for optical elements within the EOCB. WO02/31562 (Siemens) describes an arrangement in which a substrate extends vertically (normal to the EOCB surface) into an aperture and support an electro optical device or a reflector.

The invention is directed towards achieving an improved apparatus with an EOCB and electro optical devices. Specifically, an object of the invention is to achieve a simpler manner of manufacturing an electro optical apparatus, and/or reduced risk of malfunctioning of the apparatus in use.

### Summary of the Invention

We describe an electro optical apparatus comprising:
an EOCB comprising a printed circuit board having at least one waveguide within the board, and at least one optical aperture in the board with a side wall aligned with a termination of the waveguide, and
at least one electro optical device comprising a transmitter or a receiver optical element on a substrate, the optical element comprising an optical component in encapsulation,
wherein the optical element is located within the optical aperture in a manner aligned with the waveguide termination, in which the encapsulation forms and/or encapsulates an optical guide for direction of light into or out of the waveguide, and wherein the substrate is surface mounted to the board around a rim of the aperture.

In some preferred examples, the device substrate is configured for surface mount attachment to the board by a solder reflow process.

In some preferred examples, the substrate comprises a component substrate directly supporting the optical component and encapsulation and being attached to an interposer, and the interposer is surface mounted to the EOCB. In some preferred examples, at least one optical aperture is a blind aperture.

In some preferred examples, at least one optical aperture is a through hole, and the apparatus further comprises a cover over the aperture on an opening opposed to an opening covered by the device substrate.

In some preferred examples, the substrate comprises a closed loop ground plane surrounding the optical element and which is electrically attached to a corresponding closed loop ground plane of the EOCB and surrounding the optical aperture. In some preferred examples, said loop ground planes form a physical seal around the rim of the optical aperture (558).

In some preferred examples, the substrate comprises conductors which are aligned with conductors through some or all of the EOCB, thereby forming a Faraday cage around the optical aperture. Preferably, the EOCB conductors are plated through vias. Preferably, the substrate conductors are linked with a planar ground plane on a side of the substrate opposed to the EOCB.

In some preferred examples, the EOCB conductors are linked with a planar ground plane on a side of the EOCB opposed to the optical aperture opening covered by the device substrate.

In some preferred examples, the device substrate comprises an interposer which is mounted to the EOCB around a rim of the aperture, and the interposer supports at least one electronic component (601) which fits within the aperture laterally of the optical element.

We also describe a method of manufacturing an apparatus of any example, the method comprising providing the EOCB, providing at least one device, and mounting the device to the EOCB by surface mount attachment of the substrate to the rim of the aperture with the device optical element being accommodated within the optical aperture.

In some preferred examples, the EOCB aperture is a through hole and the device is inspected through an opening of an opposed side of the EOCB before application of a cap over said opposed opening.

### Additional Statements

We describe an electro optical apparatus comprising:
an EOCB comprising a printed circuit board having at least one waveguide within the board, and at least one optical aperture in the board with a side wall aligned with a termination of the waveguide, and
at least one electro optical device comprising a transmitter or a receiver optical element on a substrate,
wherein the optical element is located within the optical aperture in a manner aligned with the waveguide termination, and the substrate is surface mounted to the board around a rim of the aperture.

In some preferred examples, the device substrate is configured for surface mount attachment to the board by a solder reflow process.

In some preferred examples, the substrate comprises a circuit substrate directly supporting the optical element and being attached to an interposer, and the interposer is surface mounted to the board.

In some preferred examples, at least one optical aperture is a blind aperture.

In some preferred examples, at least one optical aperture is a through hole, and the apparatus further comprises a cover over the aperture on an opening opposed to an opening covered by the device substrate.

In some preferred examples, the substrate comprises a closed loop ground plane surrounding the optical element, and which is electrically attached to a corresponding closed loop ground plane of the EOCB and surrounding the optical aperture.

In some preferred examples, said loop ground planes form a physical seal around the rim of the optical aperture.

In some preferred examples, the substrate comprises conductors which are aligned with conductors through some or all of the EOCB, thereby forming a Faraday cage around the optical aperture.

In some preferred examples, wherein the EOCB conductors are plated through vias.

In some preferred examples, the substrate conductors are linked with a planar ground plane on a side of the substrate opposed to the EOCB.

In some preferred examples, the EOCB conductors are linked with a planar ground plane on a side of the EOCB opposed to the optical aperture opening covered by the device substrate.

In some preferred examples, the device substrate comprises an interposer which is mounted to the EOCB around a rim of the aperture, and the interposer supports at least one electronic component (601) which fits within the aperture laterally of the optical element.

In some preferred examples, In some preferred examples, the optical element is covered by encapsulation which forms an optical guide for direction of light into or out of an adjoining waveguide.

We also describe a method of manufacturing an apparatus of any example described herein, the method comprising providing the EOCB, providing at least one device, and mounting the device to the EOCB by surface mount attachment of the substrate to the rim of the aperture with the device optical element being accommodated within the optical aperture.

We also describe devices suitable for surface mounting to an EOCB to provide any apparatus as described herein. Such a device comprises a transmitter or a receiver optical element on a substrate, wherein the optical element is configured to be located within an EOCB optical aperture in a manner aligned with a waveguide termination, and the substrate is configured to be surface mounted to the EOCB around a rim of the aperture.

### Detailed Description of the Invention

The invention will be more clearly understood from the following description of some embodiments thereof, given by way of example only with reference to the accompanying drawings in which:
Fig. 1(a) is a plan view of an EOCB forming part of an apparatus of the invention, and
Fig. 1(b) is a cross-sectional view through the apparatus with electro optical devices have been mounted to apertures of the EOCB to provide an electro optical apparatus of the invention,
Fig. 2 is a cross sectional view of another apparatus of the invention showing a device having a substrate in one part both supporting the optical element and being attached to the rim of the EOCB aperture,
Fig. 3 is a cross sectional view of an alternative apparatus, in this case with a device having a substrate with an interposer PCB,
Fig. 4 is a cross sectional view of an apparatus in which an optical via hole passes through the entire EOCB,
Fig. 5(a) is a cross sectional view of an apparatus with ground planes in an interposer of a device and in a lower portion of the EOCB and with plated vias connecting the ground planes thus creating an effective Faraday cage, and Fig. 5(b) is a plan view,
Fig. 6 is a perspective view of a device with an interposer PCB upon which is also disposed a sealing metal and additional electronic components,
Fig. 7 is a plot of frequency vs. coupling loss for a modelled simulation of the invention.

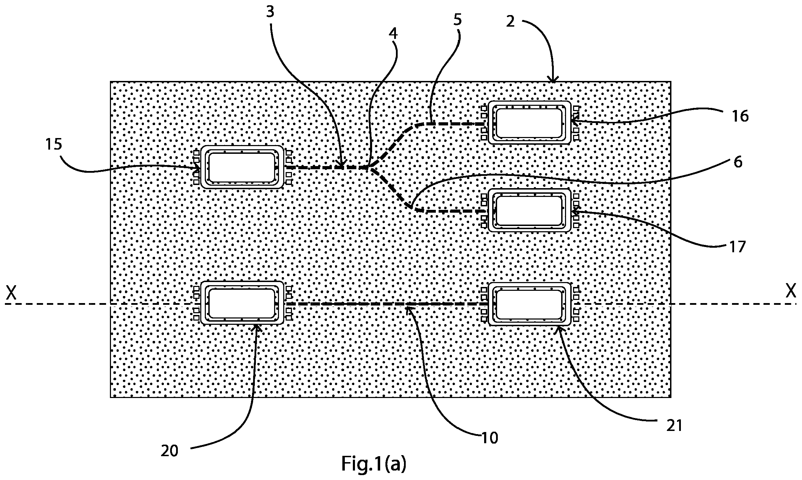

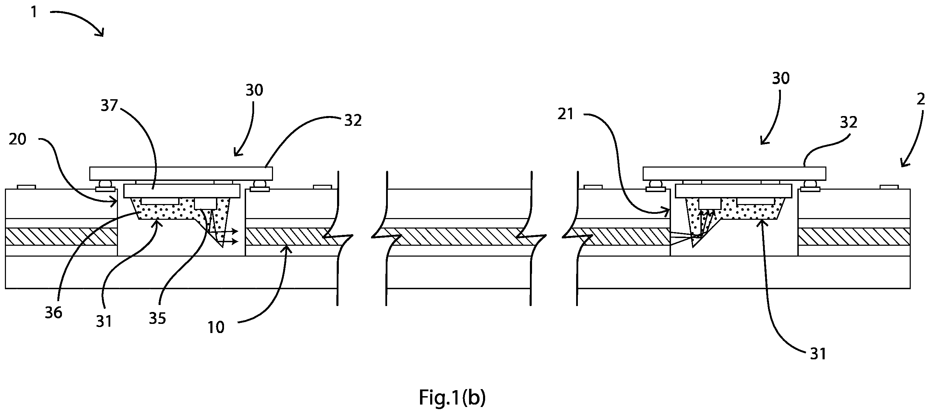

### Overview of Architecture (Figs. 1(a) and (b))

Referring to Figs. 1(a) and (b) an EOCB 2 has conductive tracks, not shown, in a conventional manner for PCBs. In addition, it has optical waveguides 3 and 10. The waveguide 3 has a primary part 4 which splits into two branches 5 and 6, arranged for optical signals transmitted from a transmitter in a blind aperture 10 to optical receivers in two blind apertures 16 and 17. The waveguide 10 has a simple straight-line configuration, linking an aperture 20 with an aperture 21, these apertures being for accommodating optical transmitters and receivers according to the circuit design.

Referring particularly to Fig. 1(b) the optical transmitters and receivers are provided by unitary electro optical devices 30, each having:
an optical element 31 comprising an active electro optical component 35 (such as a transmitter or a receiver) encapsulated in a moulding 36 which provides internal reflection so that the element 31 is in registry with the waveguide 10 facet which terminates at the aperture 20, and
a substrate comprising: (a) a direct component substrate 37 which is adhered to the encapsulation, and which on the opposite side is mounted to (b) an interposer PCB 32 which is in turn attached to the rim of the aperture 20.

Each device 30 may be regarded as a unitary package, which is placed over and partly into the aperture 20 in a single manufacturing operation. The interposer 32 (which is part of the substrate) is mounted to the board 2 around the rim of the aperture 20 by conventional solder reflow.

Because the interposer 32 is configured for surface mounting attachment in a conventional manner to the EOCB 2, providing efficient manufacturing and easy alignment of the optical elements with the waveguides. In some preferred examples the interposer also supports other components and device internal circuitry for optimum operation of the elements 31.

In other examples there is no interposer, and the direct component substrate is configured to be directly mounted to the board around the rim of the aperture. However, it is preferred that there is an interposer as it allows separation of the device substrate functions of (a) attachment to the EOCB, and (b) supporting the optical components and the encapsulation.

In various examples, the optical apertures accommodate electro optical devices which are placed with their optical elements in the apertures with a device substrate (which may or may not include an interposer) which engages the rim around the aperture on a top surface. This engagement allows the device to be correctly positioned in the aperture so that its optical transmitter or receiver is directly aligned with the relevant waveguide. The alignment is through the encapsulation, and surfaces of the encapsulation provide reflective surfaces or the encapsulation encapsulates internal reflectors or other optical guides. The substrate is arranged for surface mounting to the EOCB, thereby utilising conventional surface mount technology (SMT) for placement of the devices.

The invention provides these devices, and also an EOCB with these devices in apertures as an electro optical apparatus.

The EOCB apertures may be blind or through holes. The device substrate may have a track which forms an enclosure or ring around the EOCB aperture, thereby providing both an electrical function such as a ground plane but also providing a physical barrier to prevent ingress of contaminants. Moreover, the device substrate may have pads or plated through holes (PTHs) which are aligned with PTHs of the EOCB to provide a Faraday Cage around the device when it is placed in the aperture. Such a cage has continuity from a device substrate through at least part of the EOCB on which the device is mounted, as described in more detail below.

Each device forms a unitary subassembly which directly aligns with the EOCB waveguide without need for additional components in the EOCB aperture. In preferred examples, this registry is achieved by an over-moulding/encapsulation. For example, the light turning surface may be implemented as a surface of a transparent over-moulding over the active optical component which in turn has been fixed upon a substrate with metal solder pads and conduction paths for attachment of other required electronic components. The moulding extends into the aperture of the EOCB.

The active optical element may be a light source such as vertical cavity surface emitting laser (VCSEL), photoreceiver or sensor and the additional electronic components may include for example a VCSEL driver integrated circuit (IC) or amplifier IC and some passive electronic components. The light turning surface may reflect the light through a process of total internal reflection or the external surface of the over moulding (encapsulation) may be coated with a highly reflecting layer. It is the case therefore that the alignment of the active optical component with respect to the optical turning surface is primarily determined by the pick-and-place accuracy of the optical component onto the substrate as the position of the reflective surface with respect to the substrate is in large part fixed by the moulding process.

It is also the case that the device (unitary subassembly) can also be independently tested for quality and optical performance prior to assembly onto the EOCB and that there is no requirement to assemble the optical turning surface into the EOCB as a separate element thereby making the process simple and low cost.

The surface profile of the encapsulation from which the light beam exits the encapsulation may in some examples be modified to enable the lensing of the beam to increase the coupling into the waveguide. It is preferred that the light turning be provided by encapsulation, however it may alternatively be provided by a discrete lens in some circumstances.

Advantageously, metal pads and solder bumps are positioned on the upper surface of the EOCB that are in exact register with metal pads disposed on the surface of the substrate of the unitary device. The device is flipped (positioned such that the metal pads and solder bumps of the substrate align with those on the upper surface of the EOCB) and subsequently passed through a solder re-flow process to achieve accurate self-alignment. This achieves good optical coupling between the EOCB waveguide and active optical component and *vice-versa.* In this manner a low-cost passive assembly process enables the cost of the apparatus to be minimised.

In other examples the unitary device has a land grid array (LGA) configuration on a circuit substrate attached to the upper surface of an interposer which is in turn mounted to the EOCB. In this case the physical dimensions of the device can be reduced to a minimum allowing a larger number of pieces of the device to be simultaneously moulded and thus help minimise their unit cost.

In some examples, the aperture in the EOCB passes through both the upper and lower surfaces of the EOCB and the resulting opening in the lower surface is then covered, for example by a capping PCB. In this configuration and when the device is attached prior to the attachment of the PCB cap it is possible to inspect inside the aperture to ensure that it is free from debris and that the optical surfaces of the waveguide and unitary subassembly are unobstructed prior to attachment of the PCB cap.

In some examples a first upper ground plane is disposed in the interposer and a second lower ground plane is disposed in the lower portion of the EOCB in the case of a blind aperture or alternatively it may be disposed in the PCB cap in the case of an aperture that breaks the lower surface of the EOCB. Therefore, when the device is attached to the EOCB the optical element is sandwiched between the upper and lower ground planes. Furthermore, a series of copper plated vias connecting the upper and lower ground planes may be positioned such that they surround the optical aperture and the optical element contained therein. The combination of the upper and lower ground planes and series of plated vias provide an effective Faraday cage and it can be understood that this Faraday cage can protect the electronic components contained within the unitary subassembly from interference from external sources of electromagnetic radiation.

In other examples a continuous metal pad is disposed on the EOCB-facing surface of the device substrate such that it encircles the optical element and is in registry with an opposing continuous metal pad and solder implemented on the upper surface of the EOCB. When the device is 'flipped and attached to the upper surface of the EOCB a continuous seal is established around the optical via that will prevent the ingress of particulates and debris into the blind optical via hole.

### Moulding-supporting Substrate Directly Engaging the Board

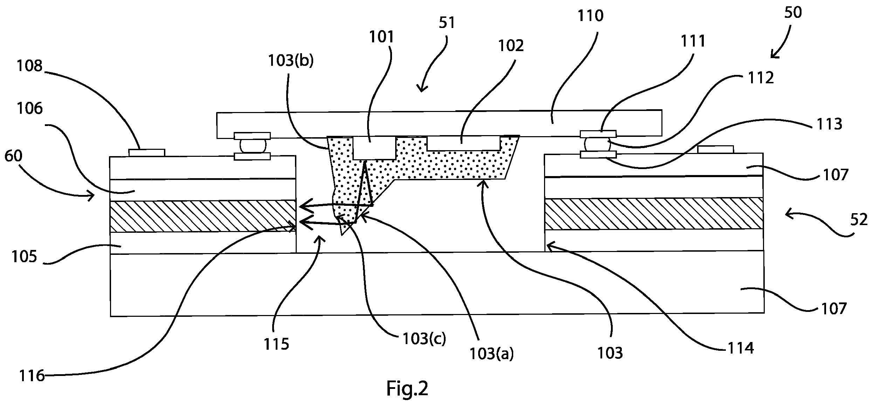

Referring to Fig. 2, an apparatus 50 of the invention comprises the EOCB 52 and a number of unitary subassembly devices 51 At least one device 51 comprises the following.
- 101: A surface light emitting component, a preferred implementation being a vertical cavity surface emitting laser (VCSEL), and Fig. 2 shows an emitted beam 115 of the surface emitting device 101.
- 102: A VCSEL driver integrated circuit.
- 110: A device substrate upon which the surface light emitting component 101 and the VCSEL driver integrated circuit 102 are attached, and which is itself directly attached to the top of the EOCB 2.
- 111: Metal bond pads on the substrate 110.
- 103: A transparent plastics encapsulation on the substrate 110 and around the components 101 and 102.
- 103(a): A surface of the plastics encapsulation 103 positioned and angled such that an emitted beam 115 from the optical component 101 is turned either by total internal reflection or as a consequence of the surface being coated with a reflective film from a vertical direction and redirected such that it propagates in the horizontal plane of the EOCB 2.
- 103(b): A near vertical surface of the plastic encapsulation 103 from which the optical beam exits the encapsulation.
- 103(c): A portion of the surface of the encapsulation 103 whose profile is shaped to provide a lens effect to increase the quantity of light that will be coupled into a waveguide 60 of the EOCB 52.

The Electro-Optical Circuit Board (EOCB) 52 has:
- 107: A printed circuit of multiple layers that supports a complex electrical circuit layout.
- 106: An embedded core of high-refractive material within the EOCB forming part of the waveguide60,
- 105: A lower cladding optical layer of low refractive index, for the waveguide 60.
- 107: An upper cladding optical layer of low refractive index.
- 116: A waveguide facet.
- 108: IIMetal interconnects on the top surface of the EOCB 50
- 113: Metal solder pads surrounding the aperture 114.
- 112: Solder bumps on the pads 113
- 114: An aperture that intersects and extends below the lower cladding layer 105.115 Light entering the waveguide 60.

The device 51 is flipped and there is then a solder re-flow process in which it is ensured there is mutual alignment of the device's metal bond pads 111 to the metal bond pads 113 and solder bumps 112 of the EOCB 2. It will be appreciated that manufacture is very simple, the device 51 being provided as a unit which is easily placed and reflowed for physical and electrical mounting, with alignment of the light 115 with the waveguide 60 without need for any other components. The device substrate 110 may have additional auxiliary components linked with the pads 111.

### Device Having a Substrate with an Interposer: Blind Optical Aperture

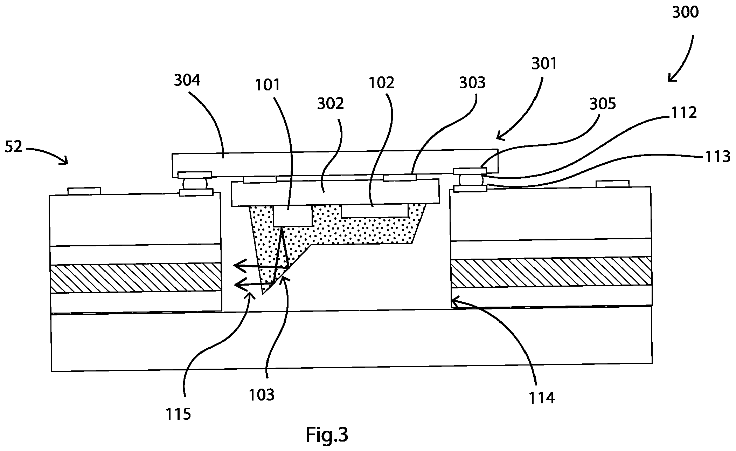

Referring to Fig. 3 an apparatus 300 of a further embodiment of the invention comprises the EOCB 52 together with at least one unitary transmitter subassembly device 301 and like parts are given the same reference numerals. In this case the device substrate comprises a Land Grid Array (LGA) substrate 302 attached to an interposer PCB 304. In more detail:
- 302,: an LGA component substrate to which the components 101 and 102 and the encapsulation 103 are mounted.
- 303,: LGA pads of the component substrate 302
- 304,: an interposer preferably of a multi-layer PCB, to which the component substrate 302 is mounted by the LGA pads 303.
- 305,: metal bond pads on the EPCB-facing surface of the interposer that are in registry with the metal bond pads 113 of the top surface of the EOCB 2.

The melting point of the solder used to attach the component substrate 302 to the interposer PCB 304 must be higher than the solder used to attach the interposer PCB 304 to the EOCB 52.

In this case the device substrate comprises both the component substrate 302 and the interposer 304, allowing manufacture of the interposer separately from the components 101 and 102 and the encapsulation 104 on the component substrate 302. The interposer 304 may have any desired auxiliary components electrically linked with the pads 305.

### Devices Having Interposers: Through Hole Optical Aperture

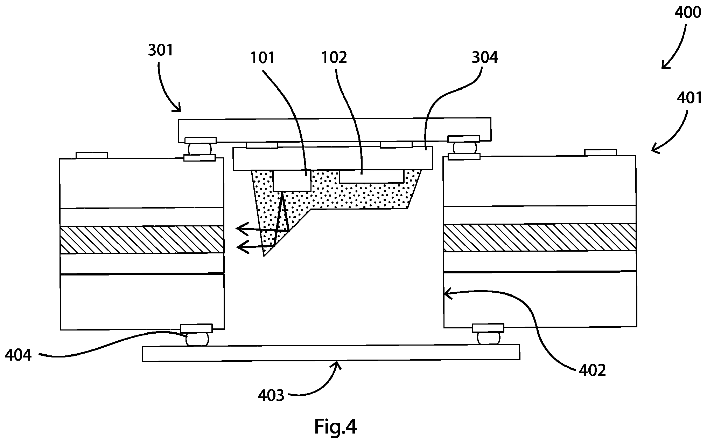

Referring to Fig. 4 an apparatus 400 comprises devices 301 and like parts are indicated by the same reference numerals. In this case each device 301 is mounted to an EOCB 401 at a through hole 402 that extends from the upper to the lower surface of the EOCB 401. The lower opening of the aperture 402 is covered by a PCB cap 403 which is attached by a ball grid array 404.

This enables an optical inspection of the device 301 after attachment to the EOCB 401 and before attachment of the cap 403. The cap 403 prevents ingress of debris and particulates through the opening in the lower surface of the EOCB.

### Apparatus with Combined Seal and Ground Plane, and Faraday Cage

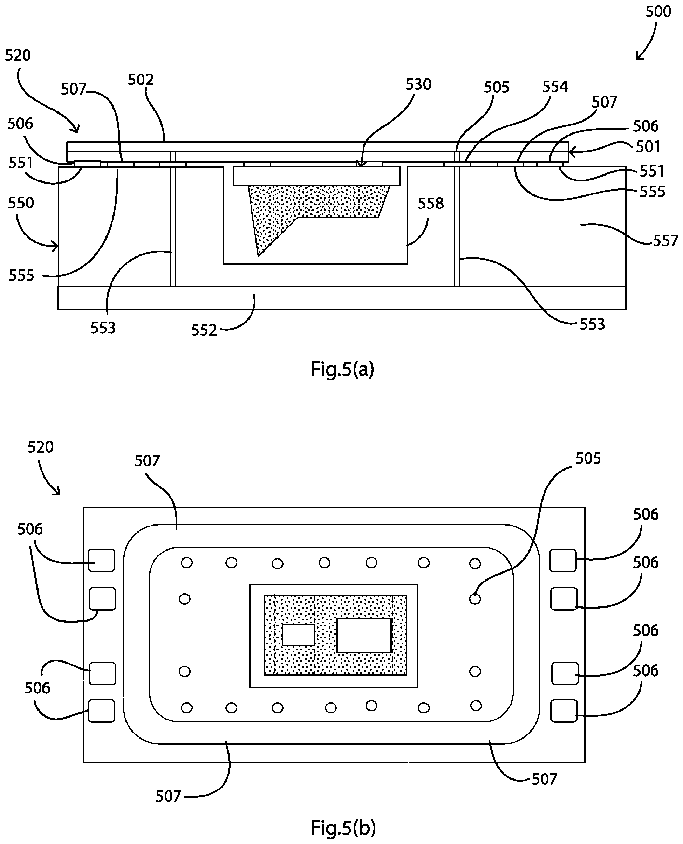

Referring to Figs 5(a) and (b) an apparatus 500 has an improved capacity to withstand electromagnetic interference (EMI) and prevent or reduce EMI-generated optical signals from a transmitter or EMI-generated false outputs from a receiver.

FIG. 5(a) is a cross section taken through part of the apparatus 500, showing a device 520 and an EOCB 550 to which it is mounted. Fig. 5(b) is a plan view of the device before it is flipped for mounting to the EOCB 550.

The device 520 has an interposer 501 and a direct component substrate supporting an optical element 530 of optical components and encapsulation. The interposer 501 has a ring-shaped ground plane 507 around its top surface (that facing the EOCB in use), and the EOCB has a ground plane 555 which matches the interposer's plane 507. When the interposer 501 is surface mounted to the EOCB 550 its ground plane 507 is soldered to the EOCB's ground plane 555. Also, the interposer 501 has eight pads 506 for signal connection to corresponding pads 551 on the EOCB 550.

Further, the interposer 501 has a bottom (facing away from the EOCB in use) ground plane 502 which is electrically linked by vertical conductors 505 through the interposer.

The EOCB 550 has a lower ground plane 552, and vertical plated through holes (PTHs) 553 extending vertically from the plane 552 and terminating in top pads 554 on the EOCB surface. The PTHs 553 and associated pads 554 are aligned with the interposer's vertical conductors 505.

These drawings also show the bulk material 557 and an aperture 558 of the EOCB 550. The device's optical element 530 fits within the aperture 558.

The upper and lower ground planes 502 and 552 are electrically connected by the multiplicity of vertical interconnections 552/554/505.

The plated vias 553 are positioned in regular intervals around the perimeter of the optical aperture 558 and thus in combination with the continuous upper and lower ground planes 502 and 552 form a Faraday cage that surrounds the components 530 and in doing so provides a high level of protection from electromagnetic interference.

The continuous metal track 507 on the EOCB-facing surface of the interposer can align with the similarly disposed track 555 and solder on the upper surface of the EOCB. The inner boundary of the metal track 507 extends beyond the perimeter of the plated vias 553. When the device 520 is attached to the EOCB 550 the metal tracks 507 and 555 form a continuous seal around the optical aperture 558 that can prevent the ingress of contaminations and debris into the aperture 558.

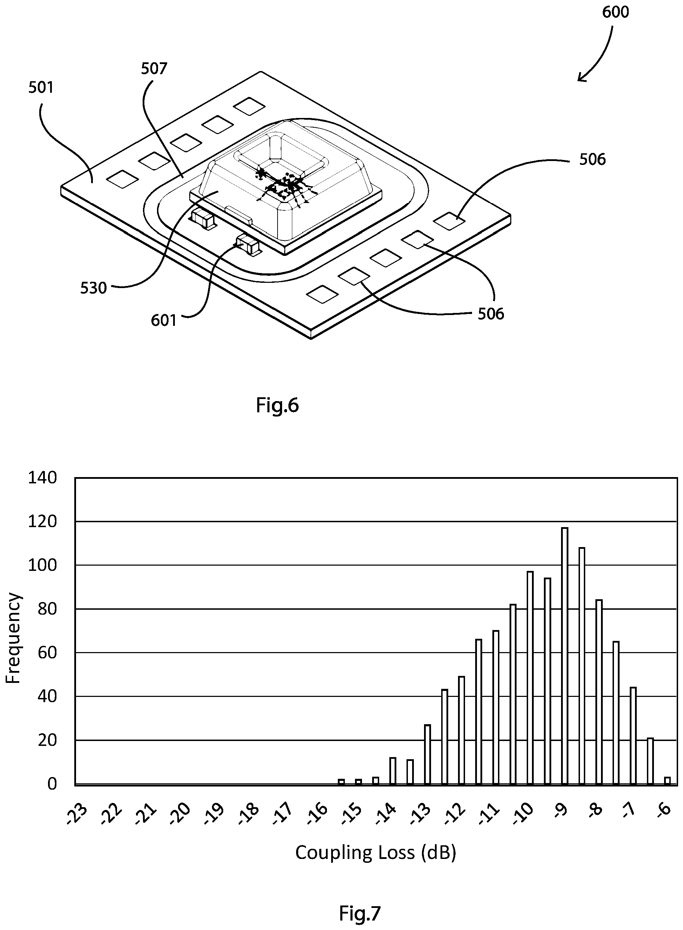

Referring to Fig. 6, this shows a device 600 from an underneath perspective. Parts like those of Figs. 5(a) and (b) are indicated by the same reference numerals. This clearly shows the interposer side facing the EOCB, with the pads 506 and additional passive electronic components such as resistors and capacitors 601 within the perimeter of the continuous metal track 507.

### Results

An optical model was developed in order to simulate what might be achievable in terms of the results of a real-world implementation of the optical interconnection. A Monte Carlo simulation was conducted on this model for 1,000 iterations utilizing a uniform probability distribution for the anticipated tolerances of the fabrication and assembly processes. The resulting optical power loss from transmitter to receiver in the optical link were then plotted and results are shown in Fig. 7. This plot demonstrates the expected occurrences of optical power loss from the optical interconnect based on the anticipated tolerances. The data in this plot demonstrates that a real-world implementation of this model would yield a successful optical interconnect across all occurrences.

Referring also to Fig. 7 an implementation of an apparatus of the invention was developed and produced. The apparatus had the configuration of Fig. 1(a), with a transmitter device (20) at one end of a straight waveguide (10) of dimensions 250 um x 250 um x 100 mm and a device receiver (21) at the other end. For this implementation, the transmitter device (20) consisted of a VCSEL and driver IC which produced an output power of 1 mW at a wavelength of 850 nm while the receiver device (21) consisted of a photodiode with a Transimpedance Amplifier (TIA) which produced an analog output representing the photodiode's response to light incident on the detector.

Evaluation was through the measurement of a full optical link of the prototype device and comparing the optical loss to the optical losses from the Monte Carlo simulation for the system. The working link from this assembly demonstrated a typical optical power loss of 11 dB, which was measured at the receiver, and is within expected optical loss range of 6 dB and 15.5 dB in the system, based on the developed model and Monte Carlo simulation.

### Advantages

The following are some of the major advantages and features.
Coupling of light into and out from the optical layer of an EOCB in a reliable, cost effective and high-volume production compatible manner.
The relative position of the active optical components with respect to the optical turning surfaces, and of the optical elements with respect to the EOCB waveguide are maintained to a high level of accuracy and repeatability.
Each device can be tested and evaluated prior to its assembly onto the EOCB.
In some examples the device has an interposer, allowing the physical dimensions of the optical components and encapsulation (if present) to be minimised and hence of low cost.
Also, the apparatus can provide a high level of EMI immunity.

It will be appreciated that each device can be configured as a transmitter or a receiver, and the EMI faraday feature is introduced as part of the embodiment with the interposer, but this same feature can be applied to any other embodiment, with the device having a substrate of any suitable type. Adding an electronic component to the interposer (or other device substrate) topside is also possible for application specific circuitry. It is possible for the VCSEL and PD to be moved within the package to adjust the height at which the light is emitted into an EOCB.

The invention is not limited to the embodiments described but may be varied in construction and detail. For example, the turning surface of the encapsulation may be plated with a highly reflective film rather than rely upon total internal reflection to redirect the optical beams. In this instance, the cavity of the optical through hole need no longer be air but can be filled with a transparent filler material to provide protection of the optical surfaces and beam paths.

## Claims

1. An electro optical apparatus comprising:
an EOCB (2) comprising a printed circuit board having at least one waveguide (3, 10) within the board, and at least one optical aperture (15, 16, 20, 402, 558) in the board with a side wall aligned with a termination (116) of the waveguide, and
at least one electro optical device (30) comprising a transmitter or a receiver optical element (31) on a substrate (32), the optical element comprising an optical component (35) in encapsulation (36, 103),
wherein the optical element (31) is located within the optical aperture in a manner aligned with the waveguide termination, in which the encapsulation forms and/or encapsulates an optical guide for direction of light into or out of the waveguide, and wherein the substrate (32, 110) is surface mounted to the board around a rim of the aperture.

2. An apparatus as claimed in claim 1, wherein the device substrate (32, 110, 304, 301) is configured for surface mount attachment to the board by a solder reflow process.

3. An apparatus as claimed in claim 1 or claim 2, wherein the substrate comprises a component substrate (302) directly supporting the optical component (101, 102) and encapsulation (103) and being attached to an interposer (32, 110, 304), and the interposer is surface mounted to the EOCB.

4. An apparatus as claimed in any preceding claim, wherein at least one optical aperture is a blind aperture (20, 114).

5. An apparatus as claimed in any preceding claim, wherein at least one optical aperture is a through hole (402), and the apparatus further comprises a cover (403) over the aperture on an opening opposed to an opening covered by the device substrate.

6. An apparatus as claimed in any preceding claim, wherein the substrate comprises a closed loop ground plane (507) surrounding the optical element and which is electrically attached to a corresponding closed loop ground plane (554) of the EOCB and surrounding the optical aperture (558).

7. An apparatus as claimed in claim 6, wherein said loop ground planes form a physical seal around the rim of the optical aperture (558).

8. An apparatus as claimed in any preceding claim, wherein the substrate comprises conductors (505) which are aligned with conductors (553) through some or all of the EOCB, thereby forming a Faraday cage around the optical aperture (558).

9. An apparatus as claimed in claim 8, wherein the EOCB conductors (553) are plated through vias.

10. An apparatus as claimed in claim 8 or claim 9, wherein the substrate conductors (505) are linked with a planar ground plane (502) on a side of the substrate (501) opposed to the EOCB (550).

11. An apparatus as claimed in any of claims 8 to 10, wherein the EOCB conductors are linked with a planar ground plane (552) on a side of the EOCB opposed to the optical aperture opening covered by the device substrate (501).

12. An apparatus as claimed in any preceding claim, wherein the device substrate comprises an interposer which is mounted to the EOCB around a rim of the aperture, and the interposer supports at least one electronic component (601) which fits within the aperture laterally of the optical element.

13. A method of manufacturing an apparatus of any preceding claim, the method comprising providing the EOCB, providing at least one device, and mounting the device to the EOCB by surface mount attachment of the substrate to the rim of the aperture with the device optical element being accommodated within the optical aperture.

14. A method as claimed in claim 13, wherein the EOCB aperture is a through hole and the device is inspected through an opening of an opposed side of the EOCB before application of a cap (403) over said opposed opening.
